# EUROPEAN PATENT SPECIFICATION

(11) **EP 4 328 601 B1**
(45) Date of publication and mention of the grant of the patent: **22.10.2025**
(21) Application number: 22919063.2
(22) Date of filing: 20.12.2022
(51) Int. Cl.: H02J 7/00, H04Q 9/00

(54) **ENERGY STORAGE SYSTEM AND METHOD FOR OPERATING SAME**
ENERGIESPEICHERSYSTEM UND VERFAHREN ZUM BETRIEB DAVON
SYSTÈME DE STOCKAGE D'ÉNERGIE ET SON PROCÉDÉ DE FONCTIONNEMENT

(30) Priority: 04.01.2022 KR 20220000989
(43) Date of publication of application: 28.02.2024
(73) Proprietor: LG Energy Solution, Ltd., Seoul 07335 (KR)
(72) Inventor: JOO, Sung Hyun, Daejeon 34122 (KR)
(74) Representative: Plasseraud IP
(86) International application number: PCT/KR2022/020852
(87) International publication number: WO 2023/132526

(56) References cited:
- WO-A1-2021/220306
- KR-A- 20130 085 203
- KR-A- 20170 059 403
- KR-A- 20170 061 446
- KR-A- 20210 047 444
- US-A1- 2012 299 721

## Description

### TECHNICAL FIELD

The present invention relates to an energy storage system and a method of operating the same, and more particularly, to an energy storage system capable of preventing data loss due to data transmission failure by dualizing data securement, and a method of operating the same.

### BACKGROUND ART

A secondary battery capable of charging/discharging is commonly applied not only to a portable device, but also to an electric vehicle or hybrid vehicle driven by an electrical source, an energy storage system (ESS) or an uninterruptible power supply (UPS) that use a medium-sized or large-sized battery for home or industrial use, etc.

Here, the energy storage system is an apparatus for improving the efficiency of power use by storing generated electricity in a storage device such as a battery and supplying it when power is needed. Such an energy storage system stores electricity generated through renewable energy such as solar and wind power or electricity transmitted from a power plant in the battery, and allows the stored power to be used at a time when power consumption is relatively high.

The secondary battery may not necessarily be the case if it is implemented as the battery for a portable terminal, etc., but a battery applied to an electric vehicle or an energy storage source as described above is generally used in a form in which a plurality of unit secondary battery cells are assembled to increase suitability for a high-capacity environment. In addition, recently, as the need for a large-capacity structure has increased, including use of the secondary battery as the energy storage source, a secondary battery pack having a multi-module structure in which a plurality of secondary batteries are connected in series/parallel, etc. is commonly used.

A unit rack for power storage is composed of a plurality of secondary battery packs, and each secondary battery pack includes a plurality of secondary battery cells or secondary battery modules. A section is composed of a plurality of banks, and the bank has a structure including a plurality of racks. The energy storage system is configured to additionally include a battery management system (BMS) that performs functions such as power supply control for the load of each battery unit, electrical characteristic value measurement such as the current or voltage, charge/discharge control, voltage equalization control, state of charge (SOC) estimation, etc.

Meanwhile, tens of thousands of secondary battery cells or secondary battery modules are included in a single energy storage system. In the operation of the energy storage systems, there is a need to constantly monitor the voltage, current, temperature, charge amount (SOC), etc. in units of tens of thousands of cells or modules, and a communication system between battery system controllers (BMSs) that transfer monitoring information from a pack battery management system (PBMS) to a rack battery management system (RBMS), from the RBMS to a bank battery management system (BBMS), and from the BBMS to a battery system controller (BSC) based on a controller area network (CAN) communication and a connection method for communication between the BMSs have been used.

As described above, the BMSs of the energy storage system are composed of the BBMS, the RBMS, the PBMS, etc. Among them, the RBMS transmits measurement data such as rack current and cell voltage to a module log receiver, that is, server, in a TCP communication method through the CAN to Ethernet Converter (CANETHEW) device, that is, a communication conversion device. The server stores the corresponding measurement data, and the measurement data stored in the server is analyzed when an unexpected failure occurs. However, when transmission of the measurement data from the communication conversion device to the server fails due to a fire or an unexpected failure, loss of the measurement data may be caused. Therefore, a dualization method of measurement data is needed so that the measurement data is not lost.

As prior art related to the present invention, there are following documents.
Korean Patent Registration No. 10-1792818
Korean Patent Registration No. 10-1726930
An example of an energy storage system comprising a battery management system is described in document WO 2021/220306 A1.

### DISCLOSURE OF THE INVENTION

### TECHNICAL PROBLEM

The present invention provides an energy storage system capable of dual management of measurement data and a method of operating the same.

The present invention provides an energy storage system capable of preventing loss of measurement data by storing the measurement data in a communication conversion device and analyzing the stored measurement data when collection of measurement data by a server is impossible, and a method of operating the same.

### TECHNICAL SOLUTION

To this end, the invention relates to an energy storage system according to claim 1.

The energy storage system after the invention may comprise one or more features from dependent claims 2 to 7, in any technically feasible combination.

The invention also relates to a method according to claim 8 of operating an energy storage system.

The method after the invention may present one or more features from claims 9 - 11, in any technically feasible combination.

### ADVANTAGEOUS EFFECTS

In the present invention, the rack BMS generates measurement data of the battery rack and transmits the measurement data to the server through the communication conversion device. In this case, the rack BMS transmits the failure flag together with the measurement data, and the failure flag is activated when the server does not receive the measurement data through the communication conversion device. If the failure flag is activated, the communication conversion device stores the measurement data in the memory, and the external controller may read the measurement data stored in the memory to store in the server and analyze the measurement data.

Therefore, in the present invention, the communication conversion device stores the measurement data that could not be transmitted to the server and analyzes the stored measurement data using the external controller, and thus it is possible to manage the measurement data in a dual way, thereby preventing the loss of the measurement data.

### BRIEF DESCRIPTION OF THE DRAWINGS

FIG. 1 is a block diagram for describing a configuration of an energy storage system according to the embodiment of the present invention.
FIG. 2 is a block diagram for describing a configuration of the rack BMS constituting the energy storage system according to the embodiment of the present invention.
FIG. 3 is a block diagram for describing a configuration of a communication conversion device constituting the energy storage system according to the embodiment of the present invention.
FIG. 4 is a flowchart illustrating a method of operating the energy storage system according to an embodiment of the present invention.

### MODE FOR CARRYING OUT THE INVENTION

Hereinafter, specific embodiments will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. In order to clearly express the various layers and each region in the drawing, the thickness is enlarged and expressed, and the same reference numerals in the drawing refers to the same elements.

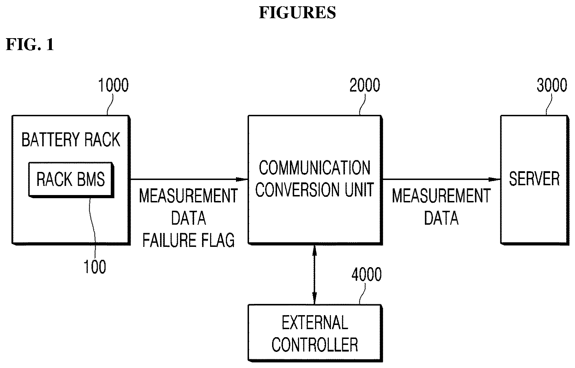

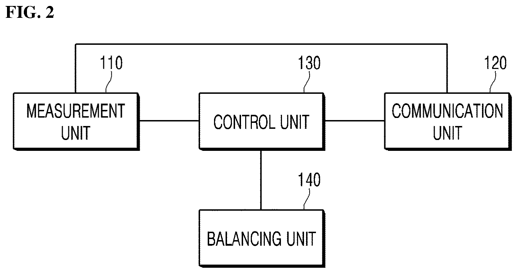

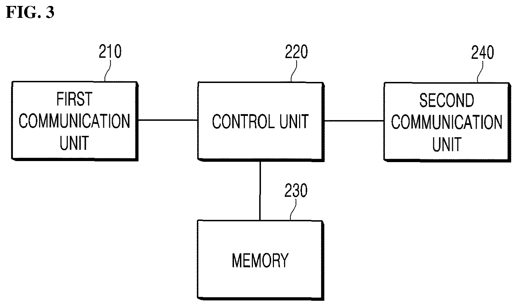

FIG. 1 is a block diagram for describing a configuration of an energy storage system according to the embodiment of the present invention. FIGS. 2 and 3 are block diagrams for describing configurations of a rack BMS and a communication conversion device constituting the energy storage system according to an embodiment of the present invention.

Referring to FIGS. 1 to 3, the energy storage system according to an embodiment of the present invention includes a rack BMS 100 that outputs measurement data and a failure flag of a battery rack 1000 including a plurality of battery cells, a communication conversion device 2000 that receives the measurement data and the failure flag from the rack BMS 100, subjects the measurement data to communication conversion and outputs the measurement data, and stores the measurement data according to activation of the failure flag, and a server 3000 that receives the measurement data from the communication conversion device 2000. In addition, the present invention may further include an external controller 4000 that reads the measurement data stored in the communication conversion device. In the present invention, when the server 3000 does not receive the measurement data transmitted from the communication conversion device 2000 due to communication failure, fire, etc., the failure flag is activated, the communication conversion device 2000 stores the measurement data at the time when the failure flag is activated depending on whether or not the failure flag is activated, and the external controller 4000 reads the stored measurement data and analyzes the measurement data. In this case, the communication conversion device 2000 stores the measurement data according to the activation of the failure flag, and the stored measurement data may be measurement data that has not been subjected to communication conversion or measurement data that has been subjected to communication conversion. Therefore, dual management of measurement data is possible and thus loss of the measurement data can be prevented. The energy storage system according to an embodiment of the present invention will be described in more detail for each configuration as follows.

### 1. Battery rack

The battery rack 1000 includes a plurality of battery cells connected in series, parallel or series-parallel, and a rack BMS 100 that manages charging and discharging of the corresponding battery rack, respectively. Here, a plurality of battery cells may constitute one battery pack, a plurality of battery packs may constitute one battery rack 1000, and a pack BMS may be provided in each battery pack. Meanwhile, a plurality of battery racks 1000 may be provided in the energy storage system. That is, the energy storage system may include a plurality of battery racks 1000, and the rack BMS 100 may be provided in each of the plurality of battery racks. The rack BMS 100 protects cells from overcharging, overdischarging, overcurrent, overheating, etc. of each cell by measuring charge and discharge information or voltage, current, etc. of each battery rack 1000 and monitoring the state of charge (SOC) and state of health (SOH) of each cell, and improves battery efficiency through cell balancing. In addition, the measurement data of the rack BMS 100 is be transmitted to the server 3000 through the communication conversion device 2000. In this case, the rack BMS 100 transmits a failure flag together with the measurement data to the communication conversion device 2000. The configuration of this rack BMS 100 is illustrated in FIG. 2.

### 1.1. Rack BMS

As illustrated in FIG. 2, the rack BMS 100 may include a measurement unit 110 for measuring a state of the battery rack 1000, a communication unit 120 for receiving and outputting data with the outside, and a control unit 130 for controlling and managing the rack BMS 100. In addition, a balancing unit 140 for balancing the battery rack 1000 may be further included.

### 1.1.1. Measurement unit

The measurement unit 110 is provided to measure the state of the battery rack 1000 and, for example, measures the voltage, current, etc. of the battery rack 1000. Here, the measurement unit 110 may measure the voltage and current of at least one of the battery pack and the battery cell as well as the battery rack. That is, the measurement unit 110 may measure the voltage, current, etc. of at least one of a battery rack, a battery pack, or a battery cell. To this end, the measurement unit 110 may include a plurality of sensors, for example, at least one voltage sensor and at least one current sensor. The voltage sensor may measure the voltage of at least one of the battery rack, the battery pack, or the battery cell. For example, the voltage of the battery rack may be measured using the voltage sensor, and a stabilized voltage after a predetermined time from the battery rack, that is, the open circuit voltage (OCV) may be measured. In addition, the current sensor may measure the current of the battery rack. The current sensor may include, for example, a Hall current transformer (Hall CT) that measures the current using a Hall element and outputs a signal corresponding to the measured current. Meanwhile, the measurement unit 110 may further include a temperature sensor (not illustrated) for measuring the temperature of the battery rack or ambient temperature. The temperature sensor may measure the temperature of one area or a plurality of areas of the battery rack or battery pack, and at least one temperature sensor may be provided for this purpose.

### 1.1.2. Communication unit

The communication unit 120 performs data input/output between the rack BMS 100 and the communication conversion device 2000. In this case, the rack BMS 100 and the communication conversion device 2000 may be connected through controller area network (CAN) communication to perform data input/output. That is, the rack BMS 100 and the communication conversion device 2000 may input and output data of CAN communication method. The communication unit 120, under the control of the control unit 130, receives measurement data from the measurement unit 110 and transfers the measurement data to the communication conversion device 2000. In addition, a buffer unit for temporarily storing data (not illustrated) may be provided at the front end of the communication unit 120. That is, the buffer unit, under the control of the control unit 130, may temporarily store data output from the measurement unit 110 and then transfer the data to the communication conversion device 2000 through the communication unit 120. In this case, the buffer unit stores next measurement data when previous measurement data is output to the communication conversion device 2000. That is, in the buffer unit, the previous measurement data may be overwritten with the next measurement data. Meanwhile, the communication unit 120 may transmit the failure flag according to an embodiment of the present invention. That is, the communication unit 120 may transmit the failure flag to the communication conversion device 2000 together with measurement data such as, for example, the rack voltage and cell current of the battery rack 1000. In this case, the communication unit 120 receives a measurement data reception completion signal output from the server 2000, and activates and outputs the failure flag when the reception completion signal is not received for a predetermined time or longer. That is, the measurement data is transmitted from the rack BMS 100 to the server 3000 through the communication conversion device 2000, the server 3000 outputs a measurement data reception completion signal when the measurement data is received, and the rack BMS 100 activates the failure flag when the reception completion signal is not received for a predetermined time and transmits the failure flag to the communication conversion device 2000. In this case, the reception completion signal from the server 3000 may be received by the communication unit 120 of the rack BMS 100 from the server 3000, or may be received by the communication unit 120 of the rack BMS 100 through the communication conversion device 2000. That is, in order to receive the reception completion signal, the communication unit 120 of the rack BMS 100 may be connected to the server 3000 or the communication conversion device 2000.

### 1.1.3. Control unit

The control unit 130 controls and manages the components constituting the rack BMS 100. That is, the control unit 130 controls the measurement unit 110 to cause the measurement unit 110 to measure the voltage, current, temperature, etc. of at least one of the battery rack, the battery pack, and the battery cell, cause the data measured therefrom to be transmitted to the communication conversion device 2000 through the communication unit 120. Here, the measurement unit 110 may continuously measure the state of the battery rack 1000 and the control unit 130 may cause data output from the measurement unit 110 to be periodically transferred to the communication conversion device 2000. Of course, the control unit 130 may transfer the corresponding data only when the current data is changed or outside a set range after comparing the previous data measured by the measurement unit 110 with the current data. In addition, the control unit 130 controls the balancing unit 140 to balance at least one selected battery cell. Meanwhile, the control unit 130 may activate the failure flag according to whether or not the reception completion signal from the server 3000 is received. That is, the control unit 130 may control the communication unit 120 to output the failure flag through the communication unit 120, and may activate the failure flag and output the failure flag through the communication unit 120 when the reception completion signal from the server 3000 is not received.

### 1.1.4. Balancing unit

The balancing unit 140 may charge or discharge all of the plurality of battery cells constituting the battery rack 1000 to balance the overall state of charge of the plurality of battery racks 1000. That is, in the plurality of battery racks 1000, the state of charge of at least one of the plurality of battery racks may be high or low. All battery cells constituting the battery rack may be charged or discharged by performing balancing through the balancing unit 140 under the control of the control unit 130 of the rack BMS 100. In this case, for the battery rack 1000 having a relatively high state of charge, all battery cells thereof may be discharged, and for the battery rack 1000 having a relatively low state of charge, all battery cells thereof may be charged. For example, the balancing unit 140 may be configured by connecting a switch and a load resistor in series between both ends of each battery cell. Accordingly, the switch may be turned on and off according to a control signal of the control unit 130 to discharge the voltage charged in the battery cell through the load resistor. In addition, in order to balance the state of charge of each battery cell constituting the battery rack 1000 under the control of the control unit 130, the balancing unit 140 may discharge cells having a relatively high state of charge and charge cells having a relatively low state of charge. That is, the measurement unit 110 may measure the voltage and current of a plurality of battery cells constituting the battery rack 1000 and the control unit 130 may discharge the cells having a high state of charge and charge the cells having a low state of charge according to the measurement result of the measurement unit 110.

### 2. Communication conversion device

The communication conversion device 2000 performs communication of measurement data between the rack BMS 100 and the server 3000. In this case, the communication conversion device 2000 is connected to the rack BMS 100 through controller area network (CAN) communication, and connected to the server 3000 through transmission control protocol (TCP) communication. Accordingly, the communication conversion device 2000 converts the CAN communication into the TCP communication and transmits the measurement data from the rack BMS 100 to the server 3000. That is, the communication conversion device 2000 receives measurement data of CAN frame format from the rack BMS 100, converts the measurement data into measurement data of TCP packet format), and then transmits the measurement data of TCP packet format to the server 3000. In addition, the communication conversion device 2000 receives the failure flag according to the present invention, and stores the measurement data received from the rack BMS 100 according to activation of the failure flag. That is, when the failure flag received from the rack BMS 100 is activated, the communication conversion device 2000 stores the corresponding measurement data. Of course, the communication conversion device 2000 may activate the failure flag. When the communication conversion device 2000 fails to receive the reception confirmation signal from the server 3000, a failure flag may be activated. The configuration of such a communication conversion device 2000 is illustrated in FIG. 3.

Referring to FIG. 3, the communication conversion device 3000 of the energy storage system according to an embodiment of the present invention may include a first communication unit 210 for receiving the measurement data and the failure flag of the battery rack 1000 through the rack BMS 100, a control unit 220 for receiving the measurement data through the first communication unit 210, subjects the measurement data to communication conversion for transmit the measurement data to the server 3000, and determines whether or not the failure flag is activated, a memory 230 that stores the measurement data when the failure flag is activated, and a second communication unit 240 for transmitting measurement data that has been subjected to communication conversion through the control unit 220 to the server 3000.

### 2.1. First communication unit

The first communication unit 210 includes a CAN communication module to receive the measurement data from the rack BMS 100 in real time, and transmits the received measurement data to the control unit 220. That is, the first communication unit 210 is connected to the communication unit 110 of the rack BMS 100 and receives the measurement data of the battery rack 1000 from the communication unit 110 of the rack BMS 100 over the CAN frame format. In addition, the first communication unit 210 receives the failure flag from the rack BMS 100 together with the measurement data and transmits the failure flag to the control unit 220.

### 2.2. Control unit

The control unit 220 subjects the measurement data transmitted in real time from the rack BMS 100 through the first communication unit 210 to communication conversion. That is, the control unit 220 includes a communication conversion unit to convert the measurement data of the CAN frame format to the measurement data of the TCP packet format, and transfers the TCP-converted measurement data to the second communication unit 240. In addition, the control unit 220 determines whether or not the failure flag received together with the measurement data through the first communication unit 210 is activated, and stores the measurement data. That is, when the server 3000 cannot receive the measurement data due to communication line failure, fire, etc., the failure flag is activated. The control unit 220 may store measurement data at the time when the failure flag is activated in the memory 230. In this case, the measurement data to be stored in the memory 230 may be measurement data that has not been subjected to communication conversion, or measurement data that has been subjected to communication conversion. The data form of the measurement data stored in the memory 230 may be determined according to a communication method with an external controller 4000 to be described later. That is, when the external controller 4000 communicates over the CAN frame format, unconverted measurement data is stored in the memory 230. When the external controller 4000 communicates over the TCP packet format, converted measurement data may be stored in the memory 230. In an embodiment of the present invention, the external controller 4000 communicates over the CAN frame format, and thus unconverted measurement data of CAN frame format may be stored in the memory 230. Meanwhile, at least two or more, for example, five memories 230 may be provided, and the measurement data may be sequentially stored in the five memories 230 whenever the failure flag is activated. That is, the control unit 220 may sequentially store the measurement data in the five memories 230 by incrementing the index whenever the failure flag is activated. In addition, if the failure flag is activated even after the measurement data is stored in the five memories 230, the control unit 220 may sequentially overwrite the measurement data in the memories from the first memory to the fifth memory.

### 2.3. Memory

The Memory 230 stores the measurement data when the failure flag is activated. That is, when it is impossible to collect data in the server 3000 due to a failure of communication line, a fire caused by a system fault, etc., the reception confirmation signal is not generated from the server 3000, the rack BMS 100 that has not received the reception confirmation signal activates and outputs the failure flag, and when it is determined that the failure flag is activated, the measurement data may be stored in the memory 230 by the control unit 220. In this case, at least two or more memories 230 may be provided. For example, the memories 230 may be provided as first to fifth memories, and measurement data may be sequentially stored in the first to fifth memories according to the number of activations of the failure flag. That is, when the first failure flag is activated, the measurement data is stored in the first memory. Whenever the second, third, fourth, and fifth failure flags are activated, the measurement data may be sequentially stored in the second to fifth memories. However, if the failure flag is activated more than five times, the measurement data is sequentially stored again in the first to fifth memories, and previously stored measurement data may be overwritten with new measurement data. The memory 230 may include a secure digital card (SD card), a flash memory, a USB memory, an external hard disk, etc. That is, the memory 230 may be configured within the communication conversion device 2000 or may be configured outside the communication conversion device 2000.

### 2.4. Second communication unit

The second communication unit 240 transmits the measurement data that has been subjected to communication conversion by the control unit 220 to the server 3000 through an external communication network. That is, the second communication unit 240 transmits the measurement data, which is converted into measurement data of the TCP packet format through the control unit 220, to the server 3000. To this end, the second communication unit 240 may be connected to the server 3000 in a wireless or wired manner. Meanwhile, a buffer unit for temporarily storing data (not illustrated) may be provided at the front end of the second communication unit 240. That is, the buffer unit, under the control of the control unit 230, may temporarily store TCP-converted measurement data and then transfer the data to the server 3000 through the second communication unit 240. The buffer unit stores next measurement data when previous measurement data is output to the server 3000. That is, in the buffer unit, the previous measurement data may be overwritten with the next measurement data. In this case, since the buffer unit temporarily stores the measurement data, when the failure flag is activated, the measurement data temporarily stored in the buffer unit may be stored in the memory 230. That is, the buffer unit may store the previous measurement data until the next measurement data is received. When the failure flag is activated, the previous measurement data stored in the buffer unit may be stored in the memory 230 without being overwritten with the next measurement data under the control of the control unit 220. In other words, when transmission of any measurement data to the server 3000 fails, the failure flag is activated, and the control unit 220 may store the measurement data, which is temporarily stored in the buffer unit, in the memory 230 according to the activated failure flag. As such, whenever the failure flag is activated, the measurement data temporarily stored in the buffer unit may be stored in the memory 230, and the measurement data may be sequentially stored in the plurality of memories 230 by incrementing an index value of the memory 230.

### 3. Server

The server 3000 is connected to the communication conversion device 2000 to receive the measurement data from the communication conversion device 2000, and stores the received measurement data. In this case, the server 3000 may be connected to the communication conversion device 2000 in the TCP packet format. That is, the server 3000 may receive and store measurement data of the TCP packet format. In addition, the server 3000 generates and outputs the reception confirmation signal when the measurement data is received. In this case, the reception confirmation signal may be transmitted from the server 3000 to the rack BMS 100, or may be transmitted to the rack BMS 100 through the communication conversion device 2000. That is, the reception confirmation signal is transmitted to the rack BMS 100, the rack BMS 100 activates the failure flag depending on whether or not the server 3000 has received the measurement data. The server 3000 and the rack BMS 100 may be connected to transmit the reception confirmation signal, and the reception confirmation signal of the server 3000 may be transmitted to the rack BMS 100 through the communication conversion device 2000. In addition, the reception confirmation signal is transferred to the communication conversion device 2000. When the communication conversion device 2000 does not receive the reception confirmation signal from the server 3000, the failure flag may be activated by the communication conversion device 2000.

### 4. External controller

The external controller 4000 may be provided to check and analyze measurement data, which is not received by server 3000, when measurement data is not received by server 3000. That is, the external controller 4000 may be connected to the communication conversion device 2000 and read the measurement data stored in the communication conversion device 2000. In this case, the external controller 4000 requests a read command to the communication conversion device 2000 together with a memory index, and the communication conversion device 2000 may transmit measurement data stored in the memory having the corresponding index to the server 3000 according to a command of the external controller 4000. The read command and the memory index of the external controller 4000 may be transmitted to the communication conversion device 2000 over the CAN frame format. Specifically, the external controller 4000 requests the read command and the memory index to the control unit 220 of the communication conversion device 2000 in a CAN communication method, and the control unit 220 transfers the measurement data stored in the memory 230 of the corresponding index to the external controller 4000. That is, the communication conversion device 2000 may transmit measurement data that the server 3000 has not received to the server 3000 according to a command of the external controller 4000. Here, the external controller 4000 may include a manager terminal connected to the communication conversion device 2000 in a wireless or wired manner. The manager terminal may include at least one selected from a computer, a laptop computer, a mobile phone, a personal digital assistant (PDA), and a smart phone.

As described above, the energy storage system according to an embodiment of the present invention includes the battery rack 1000 including the rack BMS 100, the communication conversion device 2000, and the server 3000, and the measurement data of the battery rack 1000 measured by the rack BMS 100 is transmitted to the server 3000 through the communication conversion device 2000. In this case, in the present invention, the rack BMS 100 transmits the failure flag together with the measurement data to the communication conversion device 2000, and the communication conversion device 2000 includes the memory 230 and stores the measurement data in the memory 230 when the failure flag is activated. That is, if the server 3000 fails to receive measurement data due to communication failure, fire, etc., it does not generate the reception confirmation signal. If the rack BMS 100 fails to check the reception confirmation signal for a predetermined time, the rack BMS 100 activates the failure flag and transmits it to the communication conversion device 2000, and the communication conversion device 2000 stores the measurement data in the memory 230 according to the activation of the failure flag. In this case, the memory 230 is composed of two or more memories, and the communication conversion device 2000 increments the index by one whenever the failure flag is activated, and stores the measurement data in the memory 230 having the corresponding index. When all the measurement data is stored in the plurality of memories 230, the index is reset to 1 again, and the measurement data stored in the the memory 230 is overwritten with the newly received measurement data. For example, the memory 230 is composed of five memories, and whenever the failure flag is activated, the index is incremented to sequentially store measurement data from the first memory to the fifth memory. When the index is incremented to five and the measurement data is stored up to the fifth memory, the index is reset and the measurement data stored in the memories is sequentially overwritten from the first memory to the fifth memory. That is, when the activated failure flag is received, measurement data is stored in the order from the first memory to the fifth memory. If the failure flag is activated even after the measurement data is stored up to the fifth memory, the measurement data input is overwritten over the stored measurement data in the order of from the first memory to the fifth memory. Meanwhile, the communication conversion device 2000 receives the read command together with the index value from the external controller 4000 over CAN communication, reads the measurement data of the memory 230 corresponding to the received index value, and transmits it to the server 3000. Therefore, in the present invention, since the communication conversion device 2000 stores the measurement data that could not be transmitted to the server 3000 and the stored measurement data is read using the external controller 4000, dual management of measurement data is possible, thereby capable of preventing loss of measurement data.

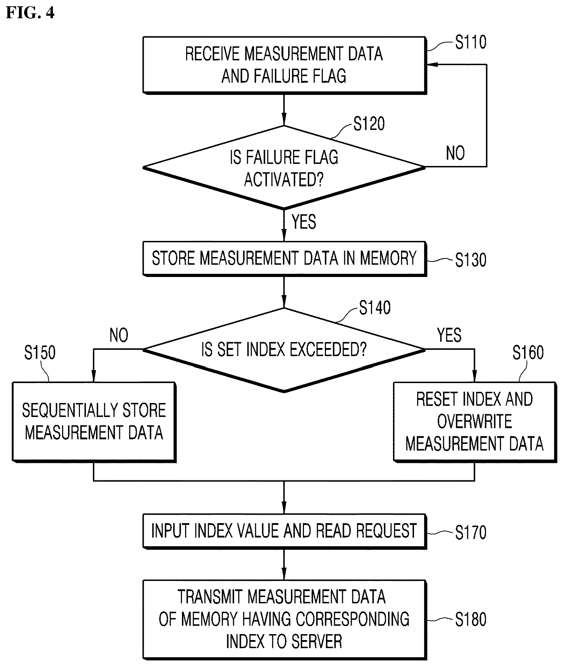

FIG. 4 is a flowchart illustrating a method of operating the energy storage system according to an embodiment of the present invention.

Referring to Fig. 4, the method of operating the energy storage system according to an embodiment of the present invention may include a process of receiving the measurement data and the failure flag of the battery rack (S110), a process of determining whether the failure flag is activated (S120), a process of storing the measurement data in a memory when the failure flag is activated (S130), a process of storing the measurement data in memory by incrementing an index whenever the failure flag is activated (S140, S150), a process of overwriting the measurement data into a memory by resetting an index when a failure flag exceeding a predetermined index is activated (S160), a process of inputting the read command together with the index value from the external controller (S170), and a process of analyzing the measurement data of the memory corresponding to the index value or storing the measurement data in the server (S180). The method of operating the energy storage system according to the embodiment of the present invention will be described in more detail for each process as follows.

S110: The rack BMS 100 measures a state of the battery rack 1000 such as the voltage, current, and temperature to generate measurement data and transmits them to the communication conversion device 2000. That is, the measurement unit 110 measures the voltage, current, temperature, etc. of at least one of the battery rack, the battery pack, and the battery cell, and the measurement data generated therefrom is transmitted to the communication conversion device 2000 through the communication unit 120. In addition, the rack BMS 100 transmits the failure flag together with the measurement data to the communication conversion device 2000. That is, the rack BMS 100 may activate the failure flag depending on whether or not the reception completion signal from the server 3000 is received. When the reception completion signal from the server 3000 is not received, the rack BMS 100 may activate the failure flag and transmit the failure flag to the communication conversion device 2000.

S120: The communication conversion device 2000 receiving the battery rack measurement data and the failure flag subjects the measurement data to communication conversion and transmits the measurement data to the server 3000. That is, the communication conversion device 2000 receives the measurement data of the CAN frame format from the rack BMS 100, converts the data into the measurement data of the TCP packet format, and transmits it to the server 300. In addition, the communication conversion device 2000 determines whether the failure flag is activated. That is, if the measurement data is received, the server 3000 may generate the reception confirmation signal and transmit it to the rack BMS 100. The rack BMS 100 may activate the failure flag when not receiving the reception confirmation signal for a predetermined time, and the communication conversion device 2000 may determine whether the failure flag received from the rack BMS 100 is activated.

S130: When the failure flag is activated, the communication conversion device 2000 stores the measurement data in the memory 230. The memory 230 may be provided inside or outside the communication conversion device 2000, and may be provided as two or more memories. Meanwhile, a buffer unit for temporarily storing the measurement data before transmission to the server 3000 may be provided in the communication conversion device 2000. The buffer unit stores next measurement data when previous measurement data is output to the server 3000. That is, in the buffer unit, the previous measurement data may be overwritten with the next measurement data. In this case, since the buffer unit temporarily stores the measurement data, when the failure flag is activated, the measurement data temporarily stored in the buffer unit may be stored in the memory 230. That is, the buffer unit may store the previous measurement data until the next measurement data is received. When the failure flag is activated, the previous measurement data stored in the buffer unit may be stored in the memory 230 without being overwritten with the next measurement data under the control of the control unit 220. In other words, when transmission of any measurement data to the server 3000 fails, the failure flag is activated, and the control unit 220 may store the measurement data, which is temporarily stored in the buffer unit, in the memory 230 according to the activated failure flag. Whenever the failure flag is activated, the measurement data temporarily stored in the buffer unit may be stored in the memory 230, and the measurement data may be sequentially stored in the plurality of memories 230 by incrementing the index value of the memory 230.

S140, S150: Whenever the failure flag is activated, the index is incremented and the measurement data is stored in the memory. In this case, the memory 230 is composed of two or more memories, and the communication conversion device 2000 increments the index by one whenever the failure flag is activated, and stores the measurement data in the memory 230 having the corresponding index. For example, the memory 230 is composed of five memories, and whenever the failure flag is activated, the index is incremented and the measurement data is sequentially stored from the first memory to the fifth memory. That is, when the activated failure flag is received, the measurement data is stored in the order from the first memory to the fifth memory.

S160: When a failure flag exceeding a predetermined index is activated the index is reset and the measurement data is overwritten into the memory. That is, when all the measurement data is stored in the plurality of memories 230, the index is reset to one again, and the measurement data stored in the memory 230 is overwritten with the newly received measurement data. For example, the memory 230 is composed of five memories, and whenever the failure flag is activated, the index is incremented and the measurement data is sequentially stored from the first memory to the fifth memory and when the index is incremented to five and the measurement data is stored up to the fifth memory, the index is reset and the the measurement data is sequentially overwritten from the first memory to the fifth memory. That is, when the activated failure flag is received, the measurement data is stored in the order from the first memory to the fifth memory. If the failure flag is activated even after the measurement data is stored up to the fifth memory, the measurement data input is overwritten in the order from the first memory to the fifth memory.

S170: The read command together with the index value are input from the external controller 4000. The external controller 4000 may be provided to check and analyze the measurement data not received by the server 3000 when the measurement data is not received by the server 3000. That is, the external controller 4000 may be connected to the communication conversion device 2000 and read the measurement data stored in the communication conversion device 2000. In this case, the external controller 4000 requests read command to the communication conversion device 2000 together with the memory index.

S180: The memory measurement data corresponding to the index value is analyzed or stored in the server. According to the command of the external controller 4000, the communication conversion device 2000 may transmit the measurement data stored in the memory having the corresponding index to the server 3000. Specifically, the external controller 4000 requests the read command and the memory index to the control unit 220 of the communication conversion device 2000, and the control unit 220 transfers the measurement data stored in the memory 230 having the corresponding index to the external controller 4000. That is, the communication conversion device 2000 may transmit measurement data not received by the server 3000 to the server 3000 according to the command of the external controller 4000.

## Claims

1. An energy storage system comprising:
a rack BMS (100) that is configured to output measurement data and a failure flag of a battery rack (1000) including a plurality of battery cells;
a communication conversion device (2000) that is configured to receive the measurement data and the failure flag from the rack BMS (100), to subject the measurement data to communication conversion, and to output the measurement data; and
a server (3000) that is configured to receive the measurement data from the communication conversion device (2000),
**characterized in that** the server (3000) is configured to transmit a reception confirmation signal to the rack BMS (100) or the communication conversion device (2000) when the measurement data is received, the rack BMS (100) or the communication conversion device (2000) activating the failure flag if the reception confirmation signal is not received, and
the communication conversion device (2000) is configured to determine whether the failure flag is activated and to store the measurement data according to activation of the failure flag.

2. The system of claim 1, wherein
the communication conversion device (2000) is configured to receive measurement data of CAN frame format from the rack BMS (100), to convert the measurement data into measurement data of TCP packet format, and then to transmit it to the server (3000). 3.

3. The system of claim 2, wherein
the communication conversion device (2000) is configured to include a plurality of memories (230) for storing the measurement data.

4. The system of claim 3, wherein
the communication conversion device (2000) is configured to increment an index whenever the failure flag is activated and sequentially to store stores the measurement data in the plurality of memories (230).

5. The system of claim 4, wherein
if the failure flag is activated even after all measurement data is stored in the plurality of memories (230), the communication conversion device (2000) is configured to reset the index and sequentially to overwrite the measurement data into the plurality of memories (230).

6. The system of any one of claims 1 to 5, further comprising:
an external controller (4000) that is configured to read the measurement data stored in the communication conversion device (2000).

7. The system of claim 6, wherein
the external controller (4000) is configured to read the measurement data stored in the corresponding memory (230) by inputting an index value and a read command to the communication conversion device (2000).

8. A method of operating an energy storage system according to any one of claims 1 to 7, comprising:
outputting measurement data and a failure flag of a battery rack (1000) by the rack BMS (100),
receiving, by the communication conversion device (2000), the measurement data and the failure flag, subjecting the measurement data to communication conversion and outputting the measurement data;
receiving the measurement data by the server, and if the measurement data is received, transmitting by the server (3000) of a reception confirmation signal to the rack BMS (100) or to the communication conversion device (2000);
when the reception confirmation signal is not received, activating the failure flag by the rack BMS (100) or the communication conversion device (2000)
determining, by the communication conversion device (2000) whether the failure flag is activated;
storing the measurement data in a memory (230) when the failure flag is activated.

9. The method of claim 8, wherein the measurement data is stored in the memory (230) by incrementing an index whenever the failure flag is activated.

10. The method of claim 9, wherein the measurement data is overwritten into the memory (230) by resetting the index when a failure flag exceeding a predetermined index is activated.

11. The method of claim 10, further comprising:
a process of inputting a read command together with an index value from an external controller (4000); and
a process of analyzing the measurement data of the memory (230) corresponding to the index value or storing the measurement data in the server (3000).

## Patentansprüche

1. Energiespeichersystem, umfassend:
ein Rack-BMS (100), welches dazu eingerichtet ist, Messdaten und eine Fehlerkennzeichnung eines Batterie-Racks (1000) auszugeben, welches eine Mehrzahl von Batteriezellen umfasst;
eine Kommunikationsumwandlungsvorrichtung (2000), welche dazu eingerichtet ist, die Messdaten und die Fehlerkennzeichnung von dem Rack-BMS (100) zu empfangen, die Messdaten einer Kommunikationsumwandlung auszusetzen und die Messdaten auszugeben; und
einen Server (3000), welcher dazu eingerichtet ist, die Messdaten von der Kommunikationsumwandlungsvorrichtung (2000) zu empfangen,
**dadurch gekennzeichnet, dass** der Server (3000) dazu eingerichtet ist, ein Empfangsbestätigungssignal an das Rack-BMS (100) oder die Kommunikationsumwandlungsvorrichtung (2000) zu übertragen, wenn die Messdaten empfangen werden, wobei das Rack-BMS (100) oder die Kommunikationsumwandlungsvorrichtung (2000) die Fehlerkennzeichnung aktiviert, wenn das Empfangsbestätigungssignal nicht empfangen wird, und
die Kommunikationsumwandlungsvorrichtung (2000) dazu eingerichtet ist, zu bestimmen, ob die Fehlerkennzeichnung aktiviert ist, und die Messdaten gemäß einer Aktivierung der Fehlerkennzeichnung zu speichern.

2. System nach Anspruch 1, wobei
die Kommunikationsumwandlungsvorrichtung (2000) dazu eingerichtet ist, Messdaten in einem CAN-Frame-Format von dem Rack-BMS (100) zu empfangen, die Messdaten in Messdaten in einem TCP-Packet-Format umzuwandeln und sie dann an den Server (3000) zu übertragen.

3. System nach Anspruch 2, wobei
die Kommunikationsumwandlungsvorrichtung (2000) dazu eingerichtet ist, eine Mehrzahl von Speichern (230) zum Speichern der Messdaten zu umfassen.

4. System nach Anspruch 3, wobei
die Kommunikationsumwandlungsvorrichtung (2000) dazu eingerichtet ist, einen Index zu inkrementieren, wann immer die Fehlerkennzeichnung aktiviert ist, und sequenziell die Messdaten in der Mehrzahl von Speichern (230) zu speichern.

5. System nach Anspruch 4, wobei,
wenn die Fehlerkennzeichnung aktiviert ist, selbst nachdem alle Messdaten in der Mehrzahl von Speichern (230) gespeichert worden sind, die Kommunikationsumwandlungsvorrichtung (2000) dazu eingerichtet ist, den Index zurückzusetzen und sequenziell die Messdaten in die Mehrzahl von Speichern (230) zu überschreiben.

6. System nach einem der Ansprüche 1 bis 5, ferner umfassend:
eine externe Steuereinrichtung (4000), welche dazu eingerichtet ist, die in der Kommunikationsumwandlungsvorrichtung (2000) gespeicherten Messdaten zu lesen.

7. System nach Anspruch 6, wobei
die externe Steuereinrichtung (4000) dazu eingerichtet ist, die in dem entsprechenden Speicher (230) gespeicherten Messdaten durch ein Eingeben eines Indexwerts und eines Lesebefehls in die Kommunikationsumwandlungsvorrichtung (2000) zu lesen.

8. Verfahren zum Betreiben eines Energiespeichersystems nach einem der Ansprüche 1 bis 7, umfassend:
Ausgeben von Messdaten und einer Fehlerkennzeichnung eines Batterie-Racks (1000) durch das Rack-BMS (100);
Empfangen, durch die Kommunikationsumwandlungsvorrichtung (2000), der Messdaten und der Fehlerkennzeichnung, Aussetzen der Messdaten einer Kommunikationsumwandlung und Ausgeben der Messdaten;
Empfangen der Messdaten durch den Server und, wenn die Messdaten empfangen werden, Übertragen, durch den Server (3000), eines Empfangsbestätigungssignals an das Rack-BMS (100) oder an die Kommunikationsumwandlungsvorrichtung (2000);
wenn das Empfangsbestätigungssignal nicht empfangen wird, Aktivieren der Fehlerkennzeichnung durch das Rack-BMS (100) oder die Kommunikationsumwandlungsvorrichtung (2000);
Bestimmen, durch die Kommunikationsumwandlungsvorrichtung (2000), ob die Fehlerkennzeichnung aktiviert ist;
Speichern der Messdaten in einem Speicher (230), wenn die Fehlerkennzeichnung aktiviert ist.

9. Verfahren nach Anspruch 8, wobei die Messdaten durch ein Inkrementieren eines Indexes, wann immer die Fehlerkennzeichnung aktiviert ist, in dem Speicher (230) gespeichert werden.

10. Verfahren nach Anspruch 9, wobei die Messdaten durch ein Zurücksetzen des Indexes, wenn eine Fehlerkennzeichnung aktiviert ist, welche einen vorbestimmten Index überschreitet, in den Speicher (230) überschrieben werden.

11. Verfahren nach Anspruch 10, ferner umfassend:
einen Prozess eines Eingebens eines Lesebefehls zusammen mit einem Indexwert von einer externen Steuereinrichtung (4000); und
einen Prozess eines Analysierens der Messdaten des Speichers (230), welche dem Indexwert entsprechen, oder eines Speicherns der Messdaten in dem Server (3000).

## Revendications

1. Un système de stockage d'énergie comprenant :
un système de gestion de batterie (BMS) de rack (100) qui est configuré pour émettre en sortie des données de mesure et un indicateur de défaillance d'un rack de batteries (1000) comprenant une pluralité de cellules de batterie ;
un dispositif de conversion de communication (2000) qui est configuré pour recevoir les données de mesure et l'indicateur de défaillance provenant du BMS de rack (100), pour soumettre les données de mesure à une conversion de communication et pour émettre en sortie les données de mesure ; et
un serveur (3000) qui est configuré pour recevoir les données de mesure provenant du dispositif de conversion de communication (2000),
**caractérisé en ce que** le serveur (3000) est configuré pour transmettre un signal de confirmation de réception au BMS de rack (100) ou au dispositif de conversion de communication (2000) lorsque les données de mesure sont reçues, le BMS de rack (100) ou le dispositif de conversion de communication (2000) activant l'indicateur de défaillance si le signal de confirmation de réception n'est pas reçu, et
le dispositif de conversion de communication (2000) est configuré pour déterminer si l'indicateur de défaillance est activé et pour stocker les données de mesure en fonction de l'activation de l'indicateur de défaillance.

2. Le système selon la revendication 1, dans lequel
le dispositif de conversion de communication (2000) est configuré pour recevoir des données de mesure au format de trame CAN provenant du BMS de rack (100), pour convertir les données de mesure en données de mesure au format de paquet TCP, puis pour les transmettre au serveur (3000).

3. Le système selon la revendication 2, dans lequel
le dispositif de conversion de communication (2000) est configuré pour inclure une pluralité de mémoires (230) pour stocker les données de mesure.

4. Le système selon la revendication 3, dans lequel
le dispositif de conversion de communication (2000) est configuré pour incrémenter un index chaque fois que l'indicateur de défaillance est activé et pour stocker séquentiellement les données de mesure dans la pluralité de mémoires (230).

5. Le système selon la revendication 4, dans lequel
si l'indicateur de défaillance est activé même après que toutes les données de mesure ont été stockées dans la pluralité de mémoires (230), le dispositif de conversion de communication (2000) est configuré pour réinitialiser l'index et pour écraser séquentiellement les données de mesure dans la pluralité de mémoires (230).

6. Le système selon l'une quelconque des revendications 1 à 5, comprenant en outre :
un contrôleur externe (4000) qui est configuré pour lire les données de mesure stockées dans le dispositif de conversion de communication (2000).

7. Le système selon la revendication 6, dans lequel
le contrôleur externe (4000) est configuré pour lire les données de mesure stockées dans la mémoire correspondante (230) en entrant une valeur d'index et une commande de lecture dans le dispositif de conversion de communication (2000).

8. Procédé d'exploitation d'un système de stockage d'énergie selon l'une quelconque des revendications 1 à 7, comprenant :
l'émission en sortie des données de mesure et d'un indicateur de défaillance d'un rack de batteries (1000) par le BMS (100) de rack,
la réception, par le dispositif de conversion de communication (2000), des données de mesure et de l'indicateur de défaillance, la conversion des données de mesure et l'émission en sortie des données de mesure ;
la réception des données de mesure par le serveur, et si les données de mesure sont reçues, la transmission par le serveur (3000) d'un signal de confirmation de réception au BMS de rack (100) ou au dispositif de conversion de communication (2000) ;
lorsque le signal de confirmation de réception n'est pas reçu, l'activation de l'indicateur de défaillance par le BMS de rack (100) ou le dispositif de conversion de communication (2000)
la détermination, par le dispositif de conversion de communication (2000), si l'indicateur de défaillance est activé ;
le stockage des données de mesure dans une mémoire (230) lorsque l'indicateur de défaillance est activé.

9. Procédé selon la revendication 8, dans lequel les données de mesure sont stockées dans la mémoire (230) en incrémentant un index chaque fois que l'indicateur de défaillance est activé.

10. Procédé selon la revendication 9, dans lequel les données de mesure sont écrasées dans la mémoire (230) en réinitialisant l'index lorsqu'un indicateur de défaillance dépassant un index prédéterminé est activé.

11. Procédé selon la revendication 10, comprenant en outre :
un processus d'entrée d'une commande de lecture avec une valeur d'index provenant d'un contrôleur externe (4000) ; et
un processus d'analyse des données de mesure de la mémoire (230) correspondant à la valeur d'index ou de stockage des données de mesure dans le serveur (3000).
